# EUROPÄISCHE PATENTSCHRIFT

(11) **EP 0 981 833 B1**
(45) Veröffentlichungstag und Bekanntmachung des Hinweises auf die Patenterteilung: **22.03.2006**
(21) Anmeldenummer: 98932002.3
(22) Anmeldetag: 24.04.1998
(51) Int. Cl.: H01L 27/092

(54) **INTEGRIERTE CMOS-SCHALTUNGSANORDNUNG UND VERFAHREN ZU DEREN HERSTELLUNG**
INTEGRATED CMOS CIRCUIT CONFIGURATION, AND PRODUCTION OF SAME
CONFIGURATION DE CIRCUIT CMOS INTEGRE ET MODE DE FABRICATION

(30) Priorität: 15.05.1997 DE 19720463
(43) Veröffentlichungstag der Anmeldung: 01.03.2000
(73) Patentinhaber: Infineon Technologies AG, 81669 München (DE)
(72) Erfinder: KRAUTSCHNEIDER, Wolfgang, D-83104 Hohenthann (DE); HOFMANN, Franz, D-80995 München (DE); RISCH, Lothar, D-85579 Neubiberg (DE)
(74) Vertreter: Zimmermann & Partner
(86) Internationale Anmeldenummer: PCT/DE1998/001154
(87) Internationale Veröffentlichungsnummer: WO 1998/052211

(56) Entgegenhaltungen:
- US-A- 4 799 097
- "CMOS Inverter" IBM TECHNICAL DISCLOSURE BULLETIN., Bd. 27, Nr. 12, Mai 1985, Seiten 7046-7048, XP002082101 NEW YORK US
- M. J. DECLERCQ: "Application of the Anisotropic etching of silicon to the Development of Complementary Structures" 1974 INTERNATIONAL ELECTRON DEVICES MEETING,9. Dezember 1974, Seiten 519-522, XP002082102

## Beschreibung

In CMOS-Schaltungen muß auch bei zunehmender Integrationsdichte sichergestellt werden, daß die n-Kanal-MOS-Transistoren und die p-Kanal-MOS-Transistoren von logischen Gattern gegeneinander isoliert sind. Insbesondere muß der Latch-up-Effekt, das heißt ein Durchschalten eines parasitären Thyristors zwischen einer ersten und einer zweiten Versorgungsspannung verhindert werden. Dazu werden die n-Kanal- bzw. p-Kanal-MOS-Transistoren, die gegebenenfalls in entsprechend dotierten Wannen angeordnet sind, durch Isolationsgebiete umgeben. Als Maßnahme gegen Latch-up-Effekte können zusätzliche Wannen- oder Substratkontaktierungen zum Beispiel in Form von Guard-Ringen vorgesehen werden.

Zur Erhöhung der Packungsdichte ist vorgeschlagen worden, in CMOS-Schaltungen die n-Kanal-MOS-Transistoren und p-Kanal-MOS-Transistoren jeweils in Gruppen zusammenzufassen (siehe zum Beispiel S. Saito et al., "A 1-Mbit CMOS DRAM with Fast Page Mode and Static Column Mode", IEEE J. Sol.-State Circ., vol. SC-20, p. 903, 1985). Dadurch muß der notwendige Mindestabstand zwischen n-dotierter Wanne und n-dotierten Source/Drain-Gebieten nicht zwischen den einzelnen MOS-Transistoren sondern nur zwischen den entsprechenden Gruppen eingehalten werden. Dadurch verringert sich der Platzbedarf pro Transistor.

Ferner ist vorgeschlagen worden (siehe zum Beispiel A. G. Lewis et al., "Polysilicon TFT Circuit and Performance", IEEE J. Sol.-State Circ., vol. 27, p. 1833, 1992), CMOS-Schaltungen auf der Basis von Dünnfilmtransistoren aufzubauen. Dabei werden die Substrate der n-Kanal-MOS-Transistoren und der p-Kanal-MOS-Transistoren voneinander getrennt ausgeführt. Bei dieser Bauform muß zwischen den Source/Drain-Gebieten der n-Kanal-MOS-Transistoren und der p-Kanal-MOS-Transistoren ein ausreichender Abstand für die Isolation der gesamten Anordnung eingehalten werden.

Schließlich ist vorgeschlagen worden (siehe IBM TDB, Vol. 27, Nr. 12, Mai 1985, Seiten 6968 bis 6970), zur Herstellung einer CMOS-Schaltung auf einem Siliziumsubstrat eine isolierende Schicht aufzubringen. An der Oberfläche der isolierenden Schicht wird eine Polysiliziumschicht aufgewachsen und durch laterale Epitaxie lokal in eine monokristalline Schicht verwandelt. In dem Siliziumsubstrat werden die n-Kanal-MOS-Transistoren gebildet. In der aufgewachsenen Schicht werden p-Kanal-MOS-Transistoren gebildet. Die Transistoren werden jeweils durch sie umgebende Isolationsgebiete isoliert. In der fertigen Anordnung sind die n-Kanal-MOS-Transistoren und die p-Kanal-MOS-Transistoren durch die isolierende Schicht und die Isolationsgebiete vollständig gegeneinander isoliert. Latch-up kann wegen der isolierenden Schicht prinzipiell nicht vorkommen. Der Flächenbedarf dieser CMOS-Schaltung ist jedoch wegen der die Transistoren umgebenden Isolationsgebiete relativ groß.

Ferner beschreibt JBMTDB, Vol. 27, Nr. 25, Mai 1985, Seiten 7046 -7048, in einer integrierten CMOS-Schaltungsanordnung in einer Hauptfläche eines Halbleitersubstrats mindestens einen Graben anzuordnen. An der Hauptfläche ist ein erster MOS-Transistor und am Boden des Grabens ein zweiter MOS-Transistor angeordnet. Der zweite MOS-Transistor ist zum ersten MOS-Transistor komplementär. Der erste MOS-Transistor und der zweite MOS-Transistor sind dabei so angeordnet, daß ein Stromfluß durch die MOS-Transistoren jeweils im wesentlichen parallel zu einer Seitenwand des Grabens erfolgt, die zwischen dem ersten MOS-Transistor und dem zweiten MOS-Transistor angeordnet ist. Die Isolation zwischen den Source/Drain-Gebieten des ersten MOS-Transistors und des zweiten MOS-Transistors wird in dieser Schaltungsanordnung durch die Seitenwand des Grabens gewährleistet. Für die Isolation zwischen dem ersten MOS-Transistor und dem zweiten MOS-Transistor ist daher kein lateraler Platzbedarf parallel zur Hauptfläche erforderlich. In der Projektion auf die Hauptfläche können der erste MOS-Transistor und der zweite MOS-Transistor aneinander angrenzen. Auf diese Weise wird auch in CMOS-Schaltungsanordnungen eine erhöhte Packungsdichte erreicht.

Der Erfindung liegt das Problem zugrunde, eine integrierte CMOS-Schaltungsanordnung anzugeben, die mit erhöhter Pakkungsdichte herstellbar ist. Weiterhin soll ein Verfahren zu deren Herstellung angegeben werden.

Dieses Problem wird erfindungsgemäß gelöst durch eine integrierte CMOS-Schaltungsanordnung gemäß Anspruch 1 sowie ein Verfahren zu deren Herstellung gemäß Anspruch 5. Weitere Ausgestaltungen der Erfindung gehen aus den übrigen Ansprüchen hervor.

Zur Kontaktierung der Source/Drain-Gebiete des zweiten MOS-Transistors, der am Boden des Grabens angeordnet ist, ist in dem Halbleitersubstrat unterhalb des zweiten MOS-Transistors eine dotierte, vergrabene Schicht angeordnet. Ein vertikaler Teilbereich des zu kontaktierenden Source/Drain-Gebietes des zweiten MOS-Transistors reicht dann bis zu der vergrabenen Schicht. Dieser vertikale Teilbereich kann durch Ionenimplantation hergestellt werden. Die vergrabene Schicht wird über einen oder mehrere Kontakte an die jeweils benötigten Potentiale angeschlossen. Dadurch sind die entsprechenden Source/Drain-Gebiete dann an die jeweiligen Potentiale anschließbar.

Zur Verbesserung der Latch-up-Festigkeit ist es vorteilhaft, in dem Halbleitersubstrat unterhalb des ersten MOS-Transistors und oberhalb des zweiten MOS-Transistors eine isolierende Schicht anzuordnen. Das bedeutet, daß der Abstand der isolierenden Schicht von der Hauptfläche geringer ist als die Tiefe des Grabens. Die isolierende Schicht wird somit durch den Graben unterbrochen. Die isolierende Schicht kann durch eine hochdotierte Schicht realisiert werden, die vom entgegengesetzten Leitfähigkeitstyp dotiert ist wie die Source/Drain-Gebiete des ersten MOS-Transistors. Alternativ kann die isolierende Schicht aus dielektrischem Material, zum Beispiel aus SiO₂ oder Si₃N₄ vorgesehen werden.

Vorzugsweise ist eine Leitung vorhanden, die quer zu dem Graben verläuft. Diese Leitung enthält eine erste Gateelektrode für den ersten MOS-Transistor und eine zweite Gateelektrode für den zweiten MOS-Transistor. Auf diese Weise ist eine elektrische Verbindung zwischen der ersten Gatelektrode und der zweiten Gateelektrode gebildet, ohne daß die Herstellung einer zusätzlichen justierten Verbindung zwischen der ersten Gatelektrode und der zweiten Gateelektrode erforderlich wäre.

Zur vorzugsweisen Herstellung der CMOS-Schaltungsanordnung wird in dem Halbleitersubstrat ein von einem ersten Leitfähigkeitstyp dotiertes Gebiet gebildet, das an eine Hauptfläche angrenzt. Es wird ein Graben gebildet, dessen Tiefe größer als die Tiefe des vom ersten Leitfähigkeitstyp dotierten Gebietes ist. Es wird ein Gatedielektrikum gebildet, das mindestens den Boden des Grabens und die Hauptfläche bedeckt. Es wird eine leitfähige Schicht abgeschieden, die den Graben auffüllt. Unter Verwendung einer Maske, die eine erste Gateelektrode für den ersten MOS-Transistor und eine zweite Gateelektrode für den zweiten MOS-Transistor definiert, wird in einem ersten Ätzschritt die leitfähige Schicht im Bereich der Hauptfläche durchgeätzt. Der Boden des Grabens bleibt dabei von der leitfähigen Schicht bedeckt. Dabei wird die erste Gatelektrode für den ersten MOS-Transistor gebildet. Anschließend werden Source/Drain-Gebiete für den ersten MOS-Transistor gebildet. Der Boden des Grabens ist dabei von der leitfähigen Schicht bedeckt, die als Maske wirkt. Anschließend wird in einem zweiten Ätzschritt die leitfähige Schicht auch am Boden des Grabens durchgeätzt. Dabei wird die zweite Gateelektrode gebildet. Zur Bildung von Source/Drain-Gebieten für den zweiten MOS-Transistor wird am freigelegten Boden des Grabens eine Diffusionsquelle erzeugt. Die Source/Drain-Gebiete des zweiten MOS-Transistors werden durch Ausdiffusion gebildet.

Die Diffusionsquelle wird vorzugsweise durch Aufbringen und Verfließen einer dotierten Silikatglasschicht gebildet. In diesem Fall entsteht die Diffusionsquelle selbstjustiert nur am Boden des Grabens.

Vorzugsweise wird aus der leitfähigen Schicht eine Leitung gebildet, die quer über den ersten MOS-Transistor und den zweiten MOS-Transistor verläuft und die die erste Gateelektrode und die zweite Gateelektrode enthält. Dadurch sind die erste Gateelektrode und die zweite Gateelektrode selbstjustierend elektrisch miteinander verbunden. Die Verbindung zwischen der ersten Gatelektrode und der zweiten Gateelektrode ist für logische Gatter erforderlich.

Zur Bildung eines logischen Gatters ist es vorteilhaft, den ersten MOS-Transistor und den zweiten MOS-Transistor so anzuordnen, daß die Source/Drain-Gebiete des ersten MOS-Transistor und des zweiten MOS-Transistors, die im Gatter elektrisch miteinander verbunden sein müssen, in der Projektion auf die Hauptfläche einander benachbart angeordnet sind. Zur Verbindung dieser Source/Drain-Gebiete wird dann ein Kontaktloch geöffnet, das die beiden zu verbindenden Source/Drain-Gebiete überlappt. Die Source/Drain-Gebiete werden über einen Kontakt, der das Kontaktloch auffüllt, miteinander verbunden.

Zur Verbesserung der Latch-up-Festigkeit liegt es im Rahmen der Erfindung, als Halbleitersubstrat ein SOI-Substrat zu verwenden, das eine Siliziumscheibe, eine darauf angeordnete isolierende Schicht und eine darauf angeordnete monokristalline Siliziumschicht aufweist. Der Graben wird in diesem Fall in einer solchen Tiefe gebildet, daß er durch die monokristalline Siliziumschicht und die isolierende Schicht bis in die Siliziumscheibe hineinreicht. Die isolierende Schicht verhindert in dieser Anordnung einen Latch-up zwischen dem ersten MOS-Transistor und dem zweiten MOS-Transistor.

Es liegt im Rahmen der Erfindung, mehr als einen Graben vorzusehen. Ferner kann der Querschnitt des oder der Gräben streifenförmig gewählt werden, so daß am Boden des Grabens und auf der Hauptfläche zwischen benachbarten Gräben jeweils mehrere MOS-Transistoren angeordnet sind. Die Konfiguration der CMOS-Schaltung erfolgt in diesem Fall sowohl über die Anordnung der MOS-Transistoren als auch über die Strukturierung der leitfähigen Schicht zur Bildung der Gateelektroden. Es liegt im Rahmen der Erfindung, MOS-Transistoren, die am Boden des Grabens oder an der Hauptfläche benachbart sind und die in Reihe verschaltet werden sollen, mit einem gemeinsamen Source/Drain-Gebiet zu versehen, über das sie in Reihe verschaltet sind. In der CMOS-Schaltungsanordnung können sowohl verschiedene Gatterkonfigurationen als auch Transfergateschaltungen oder Logikschaltungen realisiert werden.

Im folgenden wird die Erfindung anhand von Ausführungsbeispielen, die in den Figuren dargestellt sind, näher erläutert.
- Figur 1: zeigt einen Schnitt durch ein Halbleitersubstrat mit einer vergrabenen dotierten Schicht, einer p-dotierten Wanne, einer Channel-Stop-Schicht und einer Grabenmaske.
- Figur 2: zeigt den Schnitt durch das Halbleitersubstrat nach einer Grabenätzung und nach Bildung von isolierenden Spacern an Seitenwänden der Gräben.
- Figur 3: zeigt einen Schnitt durch das Halbleitersubstrat nach Entfernen der Grabenmaske, nach Bildung eines Gate- dielektrikums und nach Abscheidung einer leitfähigen Schicht.
- Figur 4: zeigt eine Aufsicht auf das Halbleitersubstrat nach einem ersten Ätzschritt zur Strukturierung der leitfähigen Schicht, bei der der Boden der Gräben von der leitfähigen Schicht bedeckt bleibt.
- Figur 5: zeigt den in Figur 4 mit V-V bezeichneten Schnitt durch das Halbleitersubstrat.
- Figur 6: zeigt den Schnitt durch das Halbleitersubstrat nach einem zweiten Ätzschritt zur Strukturierung der leitfähigen Schicht, bei dem der Boden der Gräben freigelegt wird und nach Bildung einer Diffusionsquelle auf dem Boden der Gräben und Bildung von Source/Drain-Gebieten am Boden der Gräben.
- Figur 7: zeigt den Schnitt durch das Halbleitersubstrat nach Entfernung der Diffusionsquelle, nach Bildung einer Maske, die ein Source/Drain-Gebiet am Boden der Gräben unbedeckt läßt, das durch Implantation mit der vergrabenen dotierten Schicht verbunden wird.
- Figur 8: zeigt den Schnitt durch das Halbleitersubstrat nach Bildung einer Passivierungsschicht, Öffnung von Kontaktlöchern zu einem Source/Drain-Gebiet an der Hauptfläche des Halbleitersubstrats und zu der vergrabenen dotierten Schicht sowie nach Bildung zu Kontakten, die die Kontaktlöcher auffüllen.
- Figur 9: zeigt einen zu Figur 8 parallelen Schnitt durch das Halbleitersubstrat nach Öffnung eines Kontaktloches in der Passivierungsschicht, das ein Source/Drain-Gebiet an der Hauptfläche und ein Source/Drain-Gebiet am Grabenboden überlappt und mit einem Kontakt verse- hen ist, der beide Source/Drain-Gebiete miteinander verbindet.
- Figur 10: zeigt eine Aufsicht auf das Halbleitersubstrat nach Bildung der in den Schnitten in Figur 8 und Figur 9 dargestellten Kontakte. Der in Figur 8 dargestellte Schnitt ist in Figur 10 mit VIII-VIII, der in Figur 9 dargestellte Schnitt ist in Figur 10 mit IX-IX bezeichnet.
- Figur 11: zeigt ein Ersatzschaltbild für das anhand von Figur 8, Figur 9 und Figur 10 erläuterte logische Gatter.
- Figur 12: zeigt einen Schnitt durch ein Halbleitersubstrat, das eine Siliziumscheibe, eine darauf angeordnete isolierende Schicht und eine darauf angeordnete monokristalline Siliziumschicht aufweist, in dem eine vergrabene dotierte Schicht gebildet wurde und in dem unter Verwendung einer Grabenmaske Gräben geätzt wurden.

In einem Halbleitersubstrat 1, zum Beispiel einer monokristallinen, n-dotierten Siliziumscheibe mit einer Grunddotierung von ca. 10¹⁵ cm⁻³ wird durch Implantation mit Bor mit einer Dosis von 10¹⁵ cm⁻³ und einer Energie von ca. 400 keV eine vergrabene dotierte Schicht 2 gebildet. Die vergrabene dotierte Schicht 2 muß so hoch dotiert sein, daß sie als vergrabene Anschlußleitung geeignet ist.

Anschließend wird unter Verwendung einer Photolackmaske durch Ionenimplantation mit Bor mit einer Energie von 120 keV und einer Dosis von ca. 10¹³ cm⁻² eine p-dotierte Wanne 3 gebildet. Die p-dotierte Wanne 3 weist eine Tiefe von zum Beispiel 0.3 µm auf. Durch eine weitere Implantation mit Bor mit einer Dosis von ca. 4 x 10¹³ cm⁻² und einer Energie von ca. 100 keV wird eine Channel-Stop-Schicht 4 gebildet, die innerhalb oder unterhalb der p-dotierten Wanne 3 liegt. Die p-dotierte Wanne 3 grenzt an einer Hauptfläche des Halbleitersubstrats 1 an.

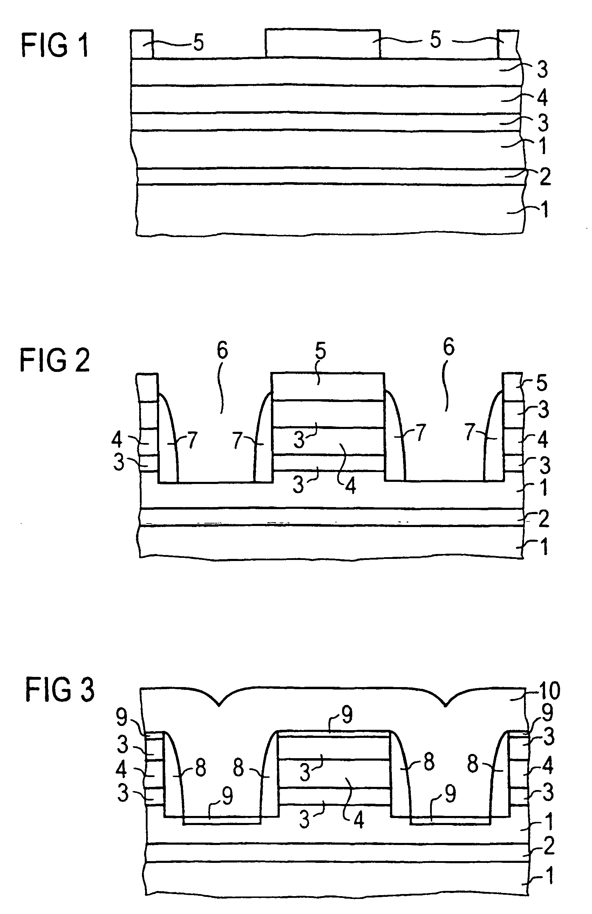

Durch Abscheidung einer SiO₂-Schicht in einem TEOS-Verfahren in einer Dicke von zum Beispiel 50 nm bis 150 nm und anschließende Strukturierung der SiO₂-Schicht mit Hilfe photolithographischer Prozeßschritte wird eine Grabenmaske 5 gebildet (siehe Figur 1). Die Grabenmaske 5 wird als Hartmaske für eine nachfolgende Grabenätzung verwendet. In einem anisotropen Ätzverfahren zum Beispiel mit HBr/Cl₂/He wird nachfolgend die Grabenätzung durchgeführt. Dabei werden zum Beispiel zwei Gräben 6 gebildet. Die Gräben 6 reichen-jeweils bis in das Halbleitersubstrat 1 unterhalb der p-dotierten Wanne 3 hinein. Sie durchqueren somit die p-Wanne 3 und die Channel-Stop-Schicht 4 (siehe Figur 2). Die Gräben 6 weisen eine Tiefe von zum Beispiel 0,5 µm auf. Die Gräben 6 weisen einen rechteckigen Querschnitt mit einer Breite von ca. 0,5 µm und einer Länge von zum Beispiel 10 µm auf.

Nachfolgend wird durch Abscheidung einer SiO₂-Schicht in einem TEOS-Verfahren mit im wesentlichen konformer Kantenbedekkung in einer Dicke von zum Beispiel 40 nm und 80 nm und anschließendes anisotropes Rückatzen isolierende Spacer 7 an den Seitenwänden der Gräben 6 gebildet. Die isolierenden Spacer 7 bedecken die freiliegende Oberfläche der p-dotierten Wanne 3 und der Channel-Stop-Schicht 4.

Anschließend wird eine Ionenimplantation zum Beispiel mit Bor bei einer Energie von zum Beispiel 25 keV und einer Dosis von zum Beispiel 1,5 x 10¹² cm⁻² durchgeführt, die als Kanalimplantation für einen nachfolgend am Boden der Gräben 6 herzustellenden MOS-Transistor dient. Anschließend wird durch naßchemisches Ätzen zum Beispiel mit HF die isolierenden Spacer 7 an den Seitenwänden der Gräben 6 entfernt. Gleichzeitig wird die Grabenmaske 5 entfernt.

Nachfolgend wird eine weitere SiO₂-Schicht in einem TEOS-Verfahren mit im wesentlichen konformer Kantenbedeckung in einer Schichtdicke von zum Beispiel 80 nm abgeschieden und anisotrop rückgeätzt. Dabei werden an den Flanken der Gräben 6 erneut isolierende Spacer 8 gebildet (siehe Figur 3). Durch thermische Oxidation wird am Boden der Gräben 6 und an der Hauptfläche ein Gatedielektrikum 9 gebildet. Das Gatedielektrikum 9 wird in einer Dicke von zum Beispiel 5 bis 10 nm gebildet.

Es wird ganzflächig eine leitfähige Schicht 10 abgeschieden. Die leitfähige Schicht 10 wird in einer solchen Dicke abgeschieden, daß die Gräben 6 damit aufgefüllt werden (siehe Figur 3). Bei einer Weite der Gräben 6 von beispielsweise 0,6 µm wird die leitfähige Schicht 10 in einer Dicke von zum Beispiel 500 nm gebildet. Für die leitfähige Schicht 10 sind alle Materialien geeignet, die zur Herstellung von Gateelektroden geeignet sind. Insbesondere wird die leitfähige Schicht 10 aus dotiertem Polysilizium mit Metallsilizid oder amorphen Silizium mit Metallsilizid erzeugt. Die leitfähige Schicht wird zum Beispiel durch Abscheidung von polykristallinem oder amorphem Silizium und anschließende Dotierung durch Implantation oder Diffusion gebildet.

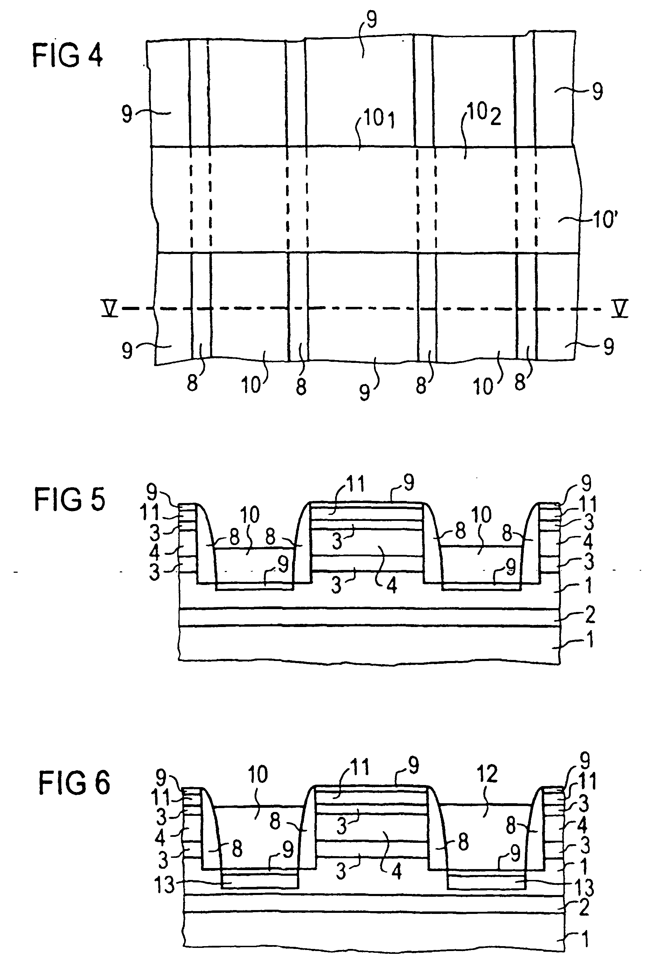

Zur Strukturierung der leitfähigen Schicht 10 wird anschließend eine Photolackmaske gebildet. Unter der Photolackmaske kann eine Antireflektionsschicht aus zum Beispiel amorphen Silizium und amorphen Siliziumnitrid aufgebracht werden. In einem ersten Ätzschritt zum Beispiel einer trockenen Ätzung mit HBr/NF₃ wird die leitfähige Schicht 10 so strukturiert, daß im Bereich der Hauptfläche eine erste Gateelektrode 10₁ entsteht (siehe Figur 4). Seitlich der ersten Gateelektrode 10₁ wird die Oberfläche des Gatedielektrikums 9 an der Hauptfläche freigelegt. Das Gatedielektrikum 9 am Boden der Gräben 6 bleibt dagegen von dem Material der leitfähigen Schicht 10 bedeckt (siehe Figur 5, in der der mit V-V bezeichnete Schnitt durch Figur 4 dargestellt ist). Nachfolgend wird eine Ionenimplantation zum Beispiel mit Arsen durchgeführt, bei der an der Hauptfläche selbstjustiert zu der ersten Gateelektrode 10₁ Source/Drain-Gebiete 11 für einen ersten MOS-Transistor gebildet werden. Die Source/Drain-Gebiete 11 sind vollständig in der p-dotierten Wanne 3 oberhalb der Channel-Stop-Schicht 4 angeordnet (siehe Figur 5). Sie weisen eine Dotierstoffkonzentration von zum Beispiel 10²⁰ cm⁻³ auf. Das an der Hauptfläche befindliche Gatedielektrikum 9 wirkt bei der Implantation als Streuoxid. Der Grabenboden wird bei der Implantation durch den dort befindlichen Teil der leitfähigen Schicht 10 maskiert.

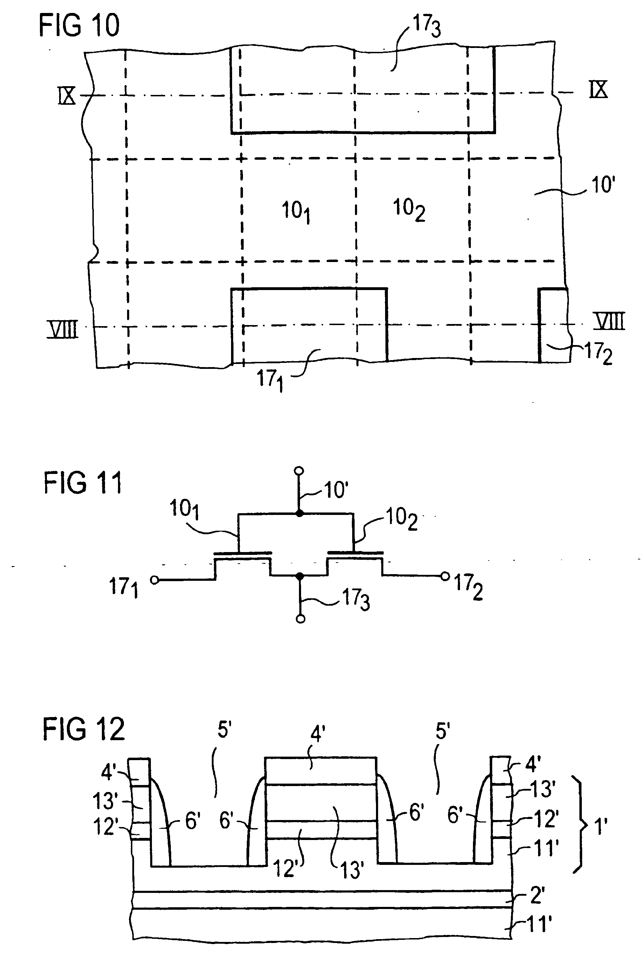

Anschließend wird in einem zweiten Ätzschritt in einem Trokkenätzverfahren zum Beispiel mit HBr/Cl₂/HeO₂ die leitfähige Schicht 10 weiter strukturiert, wobei die Oberfläche des Gatedielektrikums 9 am Boden der Gräben 6 teilweise freigelegt wird. Dabei wird eine zweite Gateelektrode 10₂ (siehe Figur 10) gebildet. Die erste Gateelektrode 10₁ und die zweite Gateelektrode 10₂ sind Bestandteil einer Leitung 10', die durch die Strukturierung der leitfähigen Schicht 10 im ersten Ätzschritt und im zweiten Ätzschritt gebildet wird und die quer zu dem Graben 6 verläuft (siehe Figur 4).

Nachfolgend wird eine Borsilikatglasschicht abgeschieden, aus der durch leichtes Verfließen und Rückätzen eine Diffusionsquelle gebildet wird, die nur in den Gräben 6 angeordnet ist (siehe Figur 6). In einem Hochtemperaturschritt wird durch Ausdiffusion von Bor aus der Diffusionsquelle 12 am Boden der Gräben 6 Source/Drain-Gebiete 13 für einen zweiten MOS-Transistor, der am Boden eines der Gräben 6 angeordnet ist, gebildet (siehe Figur 6).

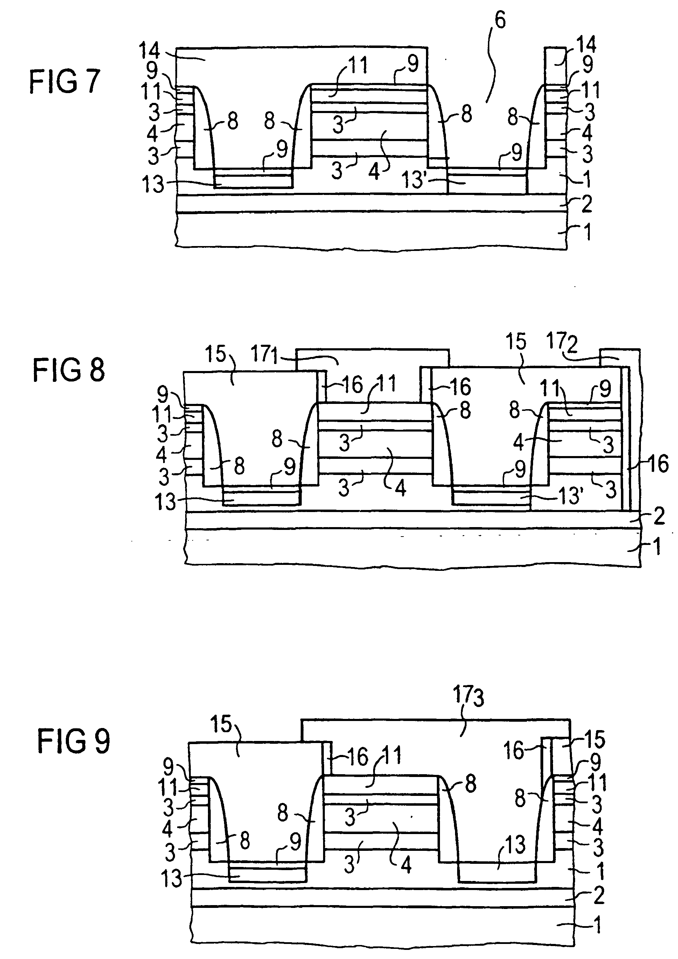

Nach Entfernen der Diffusionsquelle 12 zum Beispiel mit CHF₃ wird eine Maske 14 aus zum Beispiel Photolack gebildet, die eine Öffnung aufweist in dem Bereich eines der Source/Drain-Gebiete 13 für den zweiten MOS-Transistor, der am Boden eines der Gräben 6 angeordnet ist und das nachfolgend mit der vergrabenen dotierten Schicht 2 elektrisch verbunden werden soll. Dazu wird eine Implantation mit p-dotierenden Ionen, zum Beispiel mit Bor bei einer Energie von 180 keV oder von 100 keV und 280 keV und einer Dosis von 10¹⁵ cm⁻² durchgeführt, bei dem aus dem jeweiligen Source/Drain-Gebiet 13 ein tiefes Source/Drain-Gebiet 13' gebildet wird (siehe Figur 7). Das tiefe Source/Drain-Gebiet 13' reicht bis auf die vergrabene dotierte Schicht 2.

Die Channel-Stop-Schicht 4 wirkt als isolierende Schicht zwischen dem ersten MOS-Transistor und dem zweiten MOS-Transistor.

Nach Entfernen der Maske 14 mit zum Beispiel Photolackstrippen wird eine Zwischenoxidschicht 15 abgeschieden. In der Zwischenoxidschicht 15 werden Kontaktlöcher zu einem der Source/Drain-Gebiete 11 für den ersten MOS-Transistor, zu der vergrabenen dotierten Schicht 2 und zu dem anderen der Source/Drain-Gebiete 11 für den ersten MOS-Transistor und dem Source/Drain-Gebiet 13 für den zweiten MOS-Transistor geöffnet. Die Kontaktlöcher werden mit Flankenisolationen 16 zum Beispiel durch konforme Abscheidung einer SiO₂-Schicht und Rückätzen der SiO₂-Schicht versehen. Die Flankenisolationen 16 bewirken einerseits eine Verengung des Querschnitts des betreffenden Kontaktloches, wodurch Justierungenauigkeiten ausgeglichen und damit verbundene Kurzschlüsse vermieden werden, und andererseits eine Isolation der freigelegten Flanken der p-dotierten Wanne 3, der Channel-Stop-Schicht 4 und des Halbleitersubstrats 1 im Bereich des auf die vergrabene dotierte Schicht 2 reichenden Kontaktloches (siehe Figur 8 und Figur 9). Die Kontaktlöcher werden mit Kontakten versehen. Es wird ein erster Kontakt 17₁ zu einem der Source/Drain-Gebiete 11 für den ersten MOS-Transistor gebildet (siehe Figur 8). Ein zweiter Kontakt 17₂ wird zu der vergrabenen dotierten Schicht 2 gebildet. Ein dritter Kontakt 17₃ wird zu dem anderen Source/Drain-Gebiet 11 für den ersten MOS-Transistor und einem der Source/Drain-Gebiete 13 für den zweiten MOS-Transistor gebildet (siehe Figur 9). Der dritte Kontakt 17₃ verbindet diese beiden Source/Drain-Gebiete 11, 13 elektrisch. Das Layout der Kontakte 17₁, 17₂, 17₃ ist in Figur 10 dargestellt. In Figur 10 sind als strichpunktierte Linien VIII-VIII bzw. IX-IX die in den Figuren 8 bzw. 9 dargestellten Schnitte eingezeichnet.

In Figur 11 ist ein Ersatzschaltbild des durch den ersten MOS-Transistor und den zweiten MOS-Transistor gebildeten logischen Gatters dargestellt. Der erste Kontakt 17₁ und der zweite Kontakt 17₂ werden jeweils mit einer ersten Versorgungsspannung und einer zweiten Versorgungsspannung verbunden. Die Leitung 10', die die erste Gateelektrode 10₁ und die zweite Gateelektrode 10₂ enthält, stellt einen Eingang des logischen Gatters dar. Der dritte Kontakt 17₃ stellt einen Ausgang des logischen Gatters dar.

Alternativ kann die CMOS-Schaltungsanordnung in einem SOI-Substrat 1' anstelle des Halbleitersubstrats 1 aus monokristallinem Silizium gebildet werden (siehe Figur 12). Das SOI-Substrat 1' umfaßt eine monokristalline Siliziumscheibe 11', auf der eine isolierende Schicht 12' zum Beispiel aus SiO₂ und eine monokristalline Siliziumschicht 13' angeordnet sind. Die monokristalline Siliziumschicht 13' wird zum Beispiel p-dotiert. Die Siliziumscheibe 11' ist zum Beispiel n-dotiert. Durch Implantation wird in der Siliziumscheibe 11' eine vergrabene p-dotierte Schicht 2' gebildet.

Auf die Oberfläche der monokristallinen Siliziumschicht 13' wird eine Grabenmaske 4' aufgebracht. Die Grabenmaske 4' wird analog wie anhand von Figur 1 geschildert die Grabenmaske 5 gebildet.

Durch anisotropes Ätzen zum Beispiel mit HBr und CHF₃ werden Gräben 5' gebildet, die bis in die Siliziumscheibe 11' hineinreichen. An den Flanken der Gräben 5' werden die Oberflächen der monokristallinen Siliziumschicht 13' und der isolierenden Schicht 12' freigelegt. Durch konforme Abscheidung und anisotropes Rückätzen einer TEOS-SiO₂-Schicht werden an den Flanken der Gräben 5' Spacer 6' gebildet. Die Struktur entspricht nun der in Figur 2 dargestellten Struktur, wobei die p-dotierte monokristalline Siliziumschicht 13' die Rolle der p-dotierten Wanne 3 und die isolierende Schicht 12' die Rolle der Channel-Stop-Schicht 4 übernimmt. Die weitere Herstellung der CMOS-Schaltungsanordnung erfolgt in diesem Ausführungsbeispiel analog wie die anhand der Figuren 3 bis 11 geschilderte. In der fertigen CMOS-Schaltungsanordnung wird durch die isolierende Schicht 12' der erste MOS-Transistor gegen den zweiten MOS-Transistor dielektrisch isoliert, so daß Punch-Through-Effekte und Latch-up-Effekte wirksam unterbunden sind.

Es liegt im Rahmen der Erfindung, die Ausführungsbeispiele so abzuwandeln, daß am Grabenboden n-Kanal-MOS-Transistoren und an der Hauptfläche p-Kanal-MOS-Transistoren angeordnet werden.

## Patentansprüche

1. Integrierte CMOS-Schaltungsanordnung,
- bei der in einer Hauptfläche eines Halbleitersubstrats (1) mindestens ein Graben (6) vorhanden ist,
- bei der an der Hauptfläche ein erster MOS-Transistor und am Boden des Grabens (6) ein zweiter MOS-Transistor, der zum ersten MOS-Transistor komplementär ist, angeordnet sind,
- bei der der erste MOS-Transistor in einem von einem ersten Leitfähigkeitstyp dotierten Gebiet (3) und der zweite MOS-Transistor in einem von einem zweiten, zum ersten entgegengesetzten Leitfähigkeitstyp dotierten Gebiet (1) angeordnet sind,
- bei der der erste MOS-Transistor und der zweite MOS-Transistor so angeordnet sind, daß ein Stromfluß durch die MOS-Transistoren jeweils im wesentlichen parallel zu einer Seitenwand des Grabens erfolgt, die zwischen dem ersten MOS-Transistor und dem zweiten MOS-Transistor angeordnet ist,
**dadurch gekennzeichnet, daß**
- in dem Halbleitersubstrat (1) unterhalb des zweiten MOS-Transistors eine dotierte vergrabene Schicht (2) angeordnet ist,
- ein Source/Drain-Gebiet (13') des zweiten MOS-Transistors bis zu der vergrabenen Schicht (2) reicht,
- ein Kontakt (172) zu der vergrabenen Schicht (2) vorhanden ist.

2. Schaltungsanordnung nach Anspruch 1,
bei der in dem Halbleitersubstrat (1) unterhalb des ersten MOS-Transistors und oberhalb des zweiten MOS-Transistors eine vom ersten Leitfähigkeitstyp dotierte Schicht (4) angeordnet ist, die eine höhere Dotierstoffkonzentration als das vom ersten Leitfähigkeitstyp dotierte Gebiet (3) aufweist.

3. Schaltungsanordnung nach Anspruch 1,
bei der in dem Halbleitersubstrat (1') unterhalb des ersten MOS-Transistors und oberhalb des zweiten MOS-Transistors eine isolierende Schicht (12') angeordnet ist.

4. Schaltungsanordnung nach einem der Ansprüche 1 bis 3,
bei der eine Leitung (10') vorhanden ist, die quer zu dem Graben (6) verläuft,

5. Verfahren zur Herstellung einer integrierten CMOS-Schaltungsanordnung,
- bei dem in einer Hauptfläche eines Halbleitersubstrats ein Graben (6) gebildet wird,
- bei dem an der Hauptfläche des Halbleitersubstrats (1) ein erster MOS-Transistor gebildet wird,
- bei dem am Boden des Grabens (6) ein zweiter MOS-Transistor, der zu dem ersten MOS-Transistor komplementär ist, gebildet wird,
**dadurch gekennzeichnet, daß**
- in dem Halbleitersubstrat (1) unterhalb des zweiten MOS-Transistors eine dotierte vergrabene Schicht (2) gebildet wird,
- eines der Source/Drain-Gebiete (13) mit einer solchen Tiefe gebildet wird, daß es mit der vergrabenen Schicht (2) verbunden ist,
- ein Kontakt (172) zu der vergrabenen Schicht (2) gebildet wird.

6. Verfahren nach Anspruch 5,
- bei dem ein von einem ersten Leitfähigkeitstyp dotiertes Gebiet (3) gebildet wird, das an die Hauptfläche angrenzt,
- bei dem ein Graben (6) gebildet wird, dessen Tiefe größer als die Tiefe des vom ersten Leitfähigkeitstyp dotierten Gebietes (3) ist,
- bei dem ein Gatedielektrikum (9) gebildet wird, das mindestens den Boden des Grabens (6) und die Hauptfläche bedeckt,
- bei dem eine leitfähige Schicht (10) abgeschieden wird, die den Graben (6) auffüllt,
- bei dem eine Maske gebildet wird, die eine erste Gateelektrode (101) für den ersten MOS-Transistor und eine zweite Gateelektrode (102) für den zweiten MOS-Transistors definiert,
- bei dem in einem ersten Ätzschritt, bei dem die leitfähige Schicht (10) im Bereich der Hauptfläche durchgeätzt wird, während der Boden des Grabens (6) von der leitfähigen Schicht (10) bedeckt bleibt, die erste Gateelektrode (101) gebildet wird,
- bei dem Source/Drain-Gebiete (11) für den ersten MOS-Transistor gebildet werden,
- bei dem in einem zweiten Ätzschritt, bei dem die leitfähige Schicht (10) auch im Bereich des Bodens des Grabens (6) durchgeätzt wird, die zweite Gateelektrode (102) gebildet wird,
- bei dem zur Bildung von Source/Drain-Gebieten (13) für den zweiten MOS-Transistor am Boden des Grabens (6) eine Diffusionsquelle erzeugt wird,
- bei dem die Source/Drain-Gebiete (13) des zweiten MOS-Transistors durch Ausdiffusion gebildet werden.

7. Verfahren nach Anspruch 6,
bei dem die Diffusionsquelle (12) durch Aufbringen, Verfließen und Rückätzen einer dotierten Silikatglasschicht gebildet wird.

8. Verfahren nach Anspruch 6 oder 7,
bei dem aus der leitfähigen Schicht (10) eine Leitung (10') gebildet wird, die die erste Gateelektrode (101) und die zweite Gateelektrode (102) enthält.

9. Verfahren nach einem der Ansprüche 5 bis 8,
- bei dem der erste MOS-Transistor und der zweite MOS-Transistor so angeordnet werden, daß eines der Source/Drain-Gebiete (11) des ersten MOS-Transistors und eines der Source/Drain-Gebiete (13) des zweiten MOS-Transistors, in der Projektion auf die Hauptfläche gesehen einander benachbart angeordnet sind,
- bei dem ein Kontakt (173) gebildet wird, der diese beiden Source/Drain-Gebiete (11, 13) miteinander verbindet.

10. Verfahren nach einem der Ansprüche 5 bis 9,
bei dem in dem Halbleitersubstrat (1) unterhalb des ersten MOS-Transistors und oberhalb des zweiten MOS-Transistors eine vom ersten Leitfähigkeitstyp dotierte Schicht (4) gebildet wird, die eine höhere Dotierstoffkonzentration als das vom ersten Leitfähigkeitstyp dotierte Gebiet (3) aufweist.

11. Verfahren nach einem der Ansprüche 5 bis 9,
- bei dem als Halbleitersubstrat ein SOI-Substrat (1') mit einer Siliziumscheibe (11'), einer darauf angeordneten isolierenden Schicht (12') und einer darauf angeordneten monokristallinen Siliziumschicht (13') verwendet wird,
- bei dem der Graben (5') durch die monokristalline Siliziumschicht (13') und die isolierende Schicht (12') bis in die Siliziumscheibe (11') reicht.

## Claims

1. Integrated CMOS circuit arrangement,
- in which at least one trench (6) is present in a main area of a semiconductor substrate (1),
- in which there are arranged, at the main area, a first MOS transistor and, at the bottom of the trench (6), a second MOS transistor, which is complementary to the first MOS transistor,
- in which the first MOS transistor is arranged in a region (3) doped by a first conductivity type and the second MOS transistor is arranged in a region (1) doped by a second conductivity type, which is opposite to the first conductivity type,
- in which the first MOS transistor and the second MOS transistor are arranged in such a way that a current flow through the MOS transistors is in each case effected essentially parallel to a sidewall of the trench which is arranged between the first MOS transistor and the second MOS transistor,
**characterized in that**
- a doped buried layer (2) is arranged in the semiconductor substrate (1) below the second MOS transistor,
- a source/drain region (13') of the second MOS transistor reaches as far as the buried layer (2),
- a contact (172) to the buried layer (2) is present.

2. Circuit arrangement according to Claim 1,
in which a layer (4) doped by the first conductivity type and having a higher dopant concentration than the region (3) doped by the first conductivity type is arranged in the semiconductor substrate (1) below the first MOS transistor and above the second MOS transistor.

3. Circuit arrangement according to Claim 1,
in which an insulating layer (12') is arranged in the semiconductor substrate (1') below the first MOS transistor and above the second MOS transistor.

4. Circuit arrangement according to one of Claims 1 to 3,
in which a line (10') running transversely with respect to the trench (6) is present.

5. Method for producing an integrated CMOS circuit arrangement,
- in which a trench (6) is formed in a main area of a semiconductor substrate,
- in which a first MOS transistor is formed at the main area of the semiconductor substrate (1),
- in which a second MOS transistor is formed at the bottom of the trench (6), said second MOS transistor being complementary to the first MOS transistor,
**characterized in that**
- a doped buried layer (2) is formed in the semiconductor substrate (1) below the second MOS transistor,
- one of the source/drain regions (13) is formed with a depth such that it is connected to the buried layer (2),
- a contact (172) to the buried layer (2) is formed.

6. Method according to Claim 5,
- in which a region (3) doped by a first conductivity type and adjoining the main area is formed,
- in which a trench (6) is formed, the depth of which is greater than the depth of the region (3) doped by the first conductivity type,
- in which a gate dielectric (9) is formed, which covers at least the bottom of the trench (6) and the main area,
- in which a conductive layer (10) is deposited, which fills the trench (6),
- in which a mask is formed, which defines a first gate electrode (101) for the first MOS transistor and a second gate electrode (102) for the second MOS transistor,
- in which the first gate electrode (101) is formed in a first etching step, in which the conductive layer (10) is etched through in the region of the main area, while the bottom of the trench (6) remains covered by the conductive layer (10),
- in which source/drain regions (11) for the first MOS transistor are formed,
- in which the second gate electrode (102) is formed in a second etching step, in which the conductive layer (10) is etched through also in the region of the bottom of the trench (6),
- in which a diffusion source is produced for the formation of source/drain regions (13) for the second MOS transistor at the bottom of the trench (6),
- in which the source/drain regions (13) of the second MOS transistor are formed by outdiffusion.

7. Method according to Claim 6,
in which the diffusion source (12) is formed by applying, causing to flow and etching back a doped silicate glass layer.

8. Method according to Claim 6 or 7,
in which a line (10') containing the first gate electrode (101) and the second gate electrode (102) is formed from the conductive layer (10).

9. Method according to one of Claims 5 to 8,
- in which the first MOS transistor and the second MOS transistor are arranged in such a way that one of the source/drain regions (11) of the first MOS transistor and one of the source/drain regions (13) of the second MOS transistor are arranged adjacent to one another as viewed in the projection onto the main area,
- in which a contact (173) is formed, which connects these two source/drain regions (11, 13) to one another.

10. Method according to one of Claims 5 to 9,
in which a layer (4) doped by the first conductivity type and having a higher dopant concentration than the region (3) doped by the first conductivity type is formed in the semiconductor substrate (1) below the first MOS transistor and above the second MOS transistor.

11. Method according to one of Claims 5 to 9,
- in which an SOI substrate (1') having a silicon wafer (11'), an insulating layer (12') arranged thereon and a monocrystalline silicon layer (13') arranged thereon is used as the semiconductor substrate,
- in which the trench (5') reaches through the monocrystalline silicon layer (13') and the insulating layer (12') right into the silicon wafer (11').

## Revendications

1. Configuration de circuit CMOS intégré
- dans laquelle il y a, dans une surface principale d'un substrat (1) semi-conducteur, au moins un sillon (6) ;
- dans laquelle sont disposés sur la surface principale un premier transistor MOS et sur le fond du sillon (6) un deuxième transistor MOS qui est complémentaire du premier transistor MOS ;
- dans laquelle le premier transistor MOS est disposé dans une zone (3) dopée par un premier type de conductivité et le deuxième transistor MOS dans une zone (1) dopée par un deuxième type de conductivité opposé au premier ;
- dans laquelle le premier transistor MOS et le deuxième transistor MOS sont disposés de façon à ce qu'un flux de courant passant dans les transistors MOS se produise sensiblement parallèlement à une paroi latérale du sillon, qui est disposée entre le premier transistor MOS et le deuxième transistor MOS ;
**caractérisée en ce que**
- il est disposé dans le substrat (1) semi-conducteur en dessous du deuxième transistor MOS une couche (2) dopée qui est enfouie ;
- une zone (13') de source/drain du deuxième transistor MOS va jusqu'à la couche (2) enfouie ;
- il y a un contact (172) allant à la couche (2) enfouie.

2. Configuration de circuit suivant la revendication 1,
dans laquelle il est prévu dans le substrat (1) semi-conducteur en dessous du premier transistor MOS et au-dessus du deuxième transistor MOS une couche (4) dopée du premier type de conductivité, qui a une concentration de substance de dopage plus grande que la zone (3) dopée du premier type de conductivité.

3. Configuration de circuit suivant la revendication 1,
dans laquelle il prévu dans le substrat (1') semi-conducteur en dessous du premier transistor MOS et au-dessus du deuxième transistor MOS une couche (12') isolante.

4. Configuration de circuit suivant l'une des revendications 1 à 3,
dans laquelle il y a une ligne (10') qui s'étend transversalement au sillon (6).

5. Procédé de production d'une configuration de circuit CMOS intégré
- dans lequel on forme dans une surface principale d'un substrat semi-conducteur un sillon (6) ;
- dans lequel on forme à la surface principale du substrat (1) semi-conducteur un premier transistor MOS ;
- dans lequel on forme au fond du sillon (6) un deuxième transistor CMOS qui est complémentaire du premier transistor CMOS,
**caractérisé en ce que**
- on forme dans le substrat (1) semi-conducteur en dessous du deuxième transistor MOS une couche (2) enfouie qui est dopée ;
- on forme l'une des zones (13) de source/drain en lui donnant une profondeur telle qu'elle est reliée à la couche (2) enfouie ;
- on forme un contact (172) allant à la couche (2) enfouie.

6. Procédé suivant la revendication 5,
- dans lequel on forme une zone (3) dopée par un premier type de conductivité, qui est adjacente à la surface principale ;
- dans lequel on forme un sillon (6) dont la profondeur est plus grande que la profondeur de la zone (3) dopée par le premier type de conductivité ;
- dans lequel on forme un diélectrique (9) de grille qui recouvre au moins le fond du sillon (6) et la surface principale ;
- dans lequel on dépose une couche (10) conductrice qui remplit le sillon (6) ;
- dans lequel on forme un masque qui définit une première électrode (101) de grille pour le premier transistor MOS et une deuxième électrode (102) de grille pour le deuxième transistor MOS ;
- dans lequel on forme, dans un premier stade d'attaque, dans lequel on attaque la couche (10) conductrice dans la zone de la surface principale, tandis que le fond du sillon (6) reste recouvert par la couche (10) conductrice, la première électrode de grille ;
- dans lequel on forme des zones (11) de source/drain pour le premier transistor MOS ;
- dans lequel on forme, dans un deuxième stade d'attaque, dans lequel la couche (10) conductrice est attaquée aussi dans la zone du fond du sillon (6), la deuxième électrode (102) de grille ;
- dans lequel, pour former des zones (13) de source/drain pour le deuxième transistor MOS, on produit une source de diffusion au fond du sillon (6) ;
- dans lequel on forme les zones (13) de source/drain du deuxième transistor MOS par diffusion.

7. Procédé suivant la revendication 6,
dans lequel on forme la source (12) de diffusion par dépôt, par coulée et par attaque latérale d'une couche dopée de verre au silicate.

8. Procédé suivant la revendication 6 ou 7, dans lequel on forme à partir de la couche (10) conductrice une ligne (10') qui comporte la première électrode (101) de grille et la deuxième électrode (102) de grille.

9. Procédé suivant l'une des revendications 5 à 8,
- dans lequel on dispose le premier transistor MOS et le deuxième transistor MOS de façon à ce que l'une des zones (11) de source/drain du premier transistor MOS et l'une des zones (13) de source/drain du deuxième transistor MOS soient, tel que vue dans la projection sur la surface principale, voisines l'une de l'autre ;
- dans lequel on forme un contact (173) qui relie entre elles ces deux zones (11, 13) de source/drain.

10. Procédé suivant l'une des revendications 5 à 9,
dans lequel on forme dans le substrat (1) semi-conducteur en dessous du premier transistor MOS et au-dessus du deuxième transistor MOS une couche (4) dopée par le premier type de conductivité, qui a une concentration de substance de dopage plus grande que la zone (3) dopée par le premier type de conductivité.

11. Procédé suivant l'une des revendications 5 à 9,
- dans lequel on utilise comme substrat semi-conducteur un substrat (1') SOI ayant une tranche (11') de silicium, une couche (12') isolante disposée dessus et une couche (13') de silicium monocristallin disposée dessus ;
- dans lequel le sillon (5') va en passant à travers la couche (13') monocristalline et la couche (12') isolante jusqu'à la tranche (11') en silicium.
